# DEMANDE DE BREVET EUROPEEN

(11) **EP 4 328 597 A1**
(43) Date de publication de la demande: **28.02.2024**
(21) Numéro de dépôt: 23192338.4
(22) Date de dépôt: 21.08.2023
(51) Int. Cl.: G01R 31/36, H02J 13/00, H02J 7/00

(54) **PROCEDE D EVALUATION DE LA QUANTITE D ENERGIE ELECTRIQUE CONSOMMEE PAR UN OBJET COMMUNICANT**

(30) Priorité: 24.08.2022 FR 2208501
(71) Demandeur: Sagemcom Energy & Telecom SAS, 92500 Rueil Malmaison (FR)
(72) Inventeur: WEBER, Patrick, 92500 RUEIL MALMAISON (FR); FERRIERES, Xavier, 92500 RUEIL MALMAISON (FR)
(74) Mandataire: Cabinet Le Guen Maillet

(57) **Abrégé**

La présente invention concerne un procédé et un dispositif d'évaluation de la quantité d'énergie électrique consommée par un objet communicant alimenté par pile, l'objet communicant étant apte à exécuter une pluralité de fonctionnalités, selon l'invention :
- on détecte (E30) une activation d'une fonctionnalité de l'objet communicant,
- on vérifie (E31) dans une table, si une consommation en énergie électrique est associée à la fonctionnalité activée,
- on commande (E32) une estimation de la quantité d'énergie électrique consommée par la fonctionnalité activée si une consommation en énergie électrique est associée à la fonctionnalité activée,
- on commande (E35) une mesure de la quantité d'énergie électrique consommée par la fonctionnalité activée si une consommation en énergie électrique n'est pas associée à la fonctionnalité activée.

## Description

### DOMAINE TECHNIQUE

L'invention concerne le domaine des compteurs communicants alimentés par pile et concerne plus particulièrement le domaine de l'évaluation de la quantité d'énergie électrique consommée par un objet communicant qui soit la plus précise possible tout en consommant le moins d'énergie électrique.

### ETAT DE LA TECHNIQUE ANTERIEURE

D'une manière connue, l'Internet des Objets (IoT, « Internet of Things » en anglais) est en pleine expansion. L'Internet des Objets représente l'extension de l'Internet à des choses et à des lieux du monde physique. Alors que l'Internet ne se prolonge habituellement pas au-delà du monde électronique, l'Internet des Objets représente des échanges d'informations et de données provenant de dispositifs présents dans le monde réel vers l'Internet, comme par exemple pour la collecte de relevés de consommations d'eau ou pour la surveillance à distance de conditions environnementales (température, pression...). L'Internet des Objets est considéré comme la troisième évolution de l'Internet, baptisée Web 3.0. L'Internet des Objets revêt un caractère universel pour désigner des objets connectés aux usages variés, par exemple dans le domaine de la e-santé ou de la domotique.

Une première approche adoptée pour interconnecter des objets, appelés objets communicants (« IoT device » en anglais), dans le cadre de l'Internet des Objets, s'appuie sur un déploiement, maîtrisé par un opérateur, de passerelles de collecte situées sur des points géographiquement hauts. Hors opérations de maintenance, ces passerelles sont fixes et permanentes. On peut par exemple citer sur ce modèle les réseaux SigFox (marque déposée) ou ThingPark (marque déposée). Par exemple, en France, le réseau SigFox (marque déposée) s'appuie sur les points hauts des sites de transmission de TDF (« Télédiffusion De France »). Ces passerelles de collecte communiquent avec les objets communicants grâce à des systèmes de communication radio moyenne ou longue portée ((e.g. système LoRa (marque déposée) de la société Semtech)). Cette approche s'appuie sur un nombre limité de passerelles de collecte (difficulté de déploiement de nouvelles infrastructures réseau), ainsi que sur un accès montant (« uplink » en anglais) fiable et sécurisé avec un ou plusieurs serveurs de collecte.

Une seconde approche consiste à connecter des objets communicants au travers de passerelles résidentielles. On peut par exemple citer la technologie Energy Gateway. Un système selon la technologie Energy Gateway est composé de deux parties distinctes : d'une part, une passerelle résidentielle et des capteurs périphériques, qui sont hébergés chez le consommateur et qui permettent la collecte d'informations, la transmission de ces informations à un serveur de collecte, ainsi que le contrôle de déclenchement de diverses actions (contrôle de l'enclenchement des radiateurs ou du chauffe-eau par exemple) ; d'autre part, le serveur de collecte qui assure la mise à disposition des informations reçues et la transmission de commandes pour le contrôle de déclenchement de diverses actions. Ce serveur de collecte est accessible via l'Internet. Les technologies radio employées pour communiquer avec les objets communicants selon cette seconde approche sont de relative courte portée (par exemple de type Zigbee (marque déposée), Bluetooth (marque déposée) ou Wi-Fi (marque déposée)) pour desservir une collecte locale restreinte aux objets de l'habitat.

De tels objets communicants comportent typiquement un ou plusieurs capteurs, et sont typiquement alimentés par pile (ou batteries). Une difficulté réside dans la préservation de la durée de vie des piles, et plus particulièrement dans le fait de garantir le fonctionnement des fonctionnalités indispensables de tels objets communicants tout au long de la durée de vie des piles.

Pour cela, certains objets communicants sont équipés de systèmes d'évaluation de la quantité d'énergie restante de la batterie de manière à assurer l'intégrité des données stockées et/ou fournies par ces objets communicants lorsque leurs piles arrivent en fin de vie.

Certains systèmes d'évaluation de la quantité d'énergie restante de la batterie utilisent un système physique de mesure de la consommation électrique de l'objet communicant. Ces systèmes de mesure du courant ou de la puissance consommée sont énergivores.

D'autres systèmes d'évaluation de la quantité d'énergie restante de la batterie sont logiciels. Ces systèmes logiciels peuvent dans certains cas être imprécis.

Ainsi, il est souhaitable de fournir un procédé d'évaluation de la quantité d'énergie électrique consommée par un objet communicant qui soit la plus précise possible tout en consommant le moins d'énergie électrique.

### EXPOSE DE L'INVENTION

A cet effet, selon un premier aspect, il est proposé un procédé d'évaluation de la quantité d'énergie électrique consommée par un objet communicant alimenté par pile, l'objet communicant étant apte à exécuter une pluralité de fonctionnalités, caractérisé en que le procédé comporte les étapes de :
- détection d'une activation d'une fonctionnalité de l'objet communicant,
- vérification dans une table, si une consommation en énergie électrique est associée à la fonctionnalité activée,
- commande d'une estimation de la quantité d'énergie électrique consommée par la fonctionnalité activée si une consommation en énergie électrique est associée à la fonctionnalité activée,
- commande d'une mesure de la quantité d'énergie électrique consommée par la fonctionnalité activée si une consommation en énergie électrique n'est pas associée à la fonctionnalité activée.

Ainsi, l'évaluation de la quantité d'énergie électrique consommée par un objet communicant est précise tout en consommant un minimum d'énergie électrique.

Selon un mode particulier de l'invention, l'objet communicant est un compteur de fluide communicant.

Selon un mode particulier de l'invention, la pluralité de fonctionnalités comporte au moins une fonctionnalité affichage sur un écran, une fonctionnalité mesure de débit de fluide, une fonctionnalité communication par une liaison Bluetooth, une fonctionnalité communication par une liaison optique et une fonctionnalité communication par un canal radio.

Selon un mode particulier de l'invention, si dans la table une consommation en énergie électrique est associée à la fonctionnalité activée, le procédé comporte en outre les étapes de :
- commande d'une mesure de la quantité d'énergie électrique consommée par la fonctionnalité activée,
- vérification si l'estimation de la consommation en énergie électrique de la fonctionnalité activée correspond à la mesure de la consommation en énergie électrique de la fonctionnalité activée,
- modification dans la table de la valeur de la consommation en énergie électrique associée à la fonctionnalité si l'estimation de la consommation en énergie électrique de la fonctionnalité activée ne correspond pas à la mesure de la consommation en énergie électrique de la fonctionnalité activée.

Selon un mode particulier de l'invention, lorsque la mesure de la quantité d'énergie électrique consommée par une fonctionnalité activée est stable dans le temps, la valeur mesurée est associée à la fonctionnalité activée et est mémorisée dans la table.

L'invention concerne aussi un dispositif d'évaluation de la quantité d'énergie électrique consommée par un objet communicant alimenté par pile, l'objet communicant étant apte à exécuter une pluralité de fonctionnalités, caractérisé en que le dispositif comporte :
- des moyens de détection d'une activation d'une fonctionnalité de l'objet communicant,
- des moyens de vérification dans une table, si une consommation en énergie électrique est associée à la fonctionnalité activée,
- des moyens de commande d'une estimation de la quantité d'énergie électrique consommée par la fonctionnalité activée si une consommation en énergie électrique est associée à la fonctionnalité activée,
- des moyens de commande d'une mesure de la quantité d'énergie électrique consommée par la fonctionnalité activée si une consommation en énergie électrique n'est pas associée à la fonctionnalité activée.

Selon un autre aspect, il est proposé un produit programme d'ordinateur comprenant des instructions de code de programme pour exécuter le procédé de gestion, lorsque lesdites instructions sont exécutées par un processeur.

Selon un autre aspect, il est proposé un support de stockage non transitoire sur lequel est stocké un programme d'ordinateur comprenant des instructions de code de programme pour exécuter le procédé de gestion, lorsque lesdites instructions sont lues depuis ledit support de stockage non transitoire et exécutées par un processeur.

### BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :
[Fig. 1] illustre schématiquement un exemple d'architecture matérielle d'un objet communicant alimenté par pile ;
[Fig. 2] illustre schématiquement un exemple d'architecture matérielle d'une unité de contrôle d'un objet communicant; et
[Fig. 3] représente un exemple d'algorithme d'évaluation de la quantité d'énergie électrique consommée par un compteur communicant selon la présente invention.

### EXPOSE DETAILLE DE MODES DE REALISATION

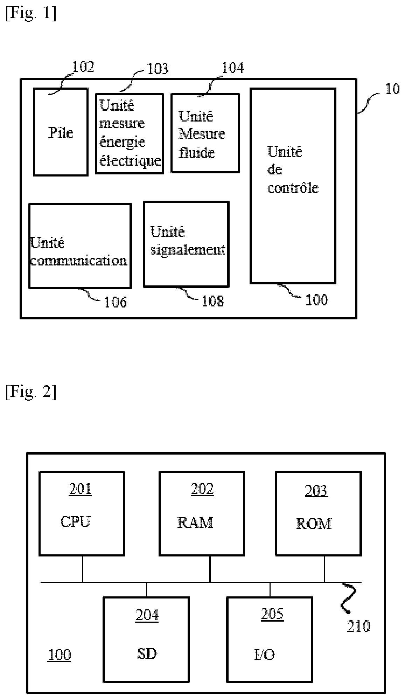

La Fig. 1 illustre schématiquement un exemple d'architecture matérielle d'un objet communicant alimenté par pile.

La présente invention est décrite dans un mode de réalisation particulier où l'objet communicant est un compteur 1 de fluide, c'est-à-dire adapté et configuré pour mesurer une consommation d'un fluide (eau, gaz...). La présente invention est aussi applicable à des objets communicants tels que des capteurs de température, de pression, d'humidité....

L'objet communicant comporte une unité de contrôle 100, une pile 102, une unité de mesure de la consommation en énergie électrique 103, une unité de mesure de fluide 104, une unité de communication 106 et une unité de signalement 108.

Il faut entendre le terme « pile » comme étant une unique pile, ou un ensemble de piles fournissant conjointement une source d'énergie électrique autonome.

Typiquement, l'unité de mesure de fluide 104 peut être adaptée et configurée pour mesurer une consommation d'eau, ou une consommation d'un autre fluide tel que du gaz. A ce titre, l'unité de mesure 4 comprend des moyens connus de mesure (métrologie) et de suivi d'une consommation d'eau.

L'unité de mesure de la consommation en énergie électrique 103 est constituée de composants électroniques aptes à mesurer un courant délivré par la pile 102 ou une puissance électrique délivrée par la pile 102 à l'objet communicant ou à une partie de l'objet communicant telle que par exemple l'unité de communication 106 . Selon l'invention, l'unité de mesure de la consommation en énergie électrique 103 est activée ou désactivée par l'unité de contrôle 100.

L'unité de communication 106 comprend un ensemble d'organes de communication permettant la transmission des mesures acquises par l'unité de mesure 104, par exemple à une passerelle de collecte ou à une passerelle résidentielle.

Typiquement, l'unité de communication 106 comprend des organes de communication via un réseau téléphonique, via Internet (protocoles de communication sur IP, via un système LoRa (marque déposée) de la société Semtech, via un système Wi-Fi (marque déposée), via un système de type ZigBee (marque déposée), via un système de type Bluetooth (marque déposée), via un système de réseau étendu à basse consommation LPWAN (« Low Power Wide Area Network » en anglais), ou via un réseau cellulaire dédié à l'internet des objets de type NB-IOT (« Narrowband Internet Of Things » en anglais) ou de type LTE Cat-M (« Long Term Evolution - Category Machine » en anglais).

L'unité de signalement 108 comprend de la circuiterie électronique pour émettre des signaux d'alarme. Typiquement, l'unité de signalement peut comprendre des organes permettant l'émission de signaux optiques (par exemple, des diodes électroluminescentes). De plus, l'unité de signalement 108 peut transmettre des signaux d'alarme via l'unité de communication 106 pour transmettre les signaux d'alarmes à des unités distantes via des systèmes sans fils tels qu'énoncés précédemment.

L'unité de contrôle 10 comprend de la circuiterie électronique pour piloter et coordonner l'ensemble des unités précédemment citées.

En outre, l'unité de contrôle 10 est adaptée pour implémenter un procédé d'évaluation de la quantité d'énergie électrique consommée par un compteur communicant selon la présente invention.

La Fig. 2 illustre schématiquement un exemple d'architecture matérielle de l'unité de contrôle 100. Selon cet exemple, l'unité de contrôle 100 comporte, reliés par un bus de communication 210 : un processeur ou CPU (« Central Processing Unit » en anglais) 201 ; une mémoire vive RAM (« Random Access Memory » en anglais) 202 ; une mémoire morte ROM (« Read Only Memory » en anglais) 203 ; une unité de stockage ou un lecteur de support de stockage, tel qu'un lecteur de cartes SD (« Secure Digital » en anglais) 204 ; un ensemble d'interfaces 205 permettant à l'unité de contrôle 10 de communiquer avec les autres éléments de l'architecture matérielle présentée ci-dessus en relation avec la Fig. 1.

Le processeur 201 est capable d'exécuter des instructions chargées dans la RAM 202 à partir de la ROM 203, d'une mémoire externe, d'un support de stockage, ou éventuellement d'un réseau de communication. Lorsque l'unité de contrôle 100 est mise sous tension, le processeur 201 est capable de lire de la RAM 202 des instructions et de les exécuter. Ces instructions forment un programme d'ordinateur causant l'implémentation, par le processeur 201, de tout ou partie du procédé d'évaluation décrit ci-après.

Ainsi, tout ou partie du procédé d'évaluation décrit ci-après peut être implémenté sous forme logicielle par exécution d'un ensemble d'instructions par une machine programmable, telle qu'un DSP (« Digital Signal Processor » en anglais), ou un microcontrôleur. Tout ou partie de l'algorithme et étapes décrits ici peut aussi être implémenté sous forme matérielle par une machine ou un composant dédié, tel qu'un FPGA (« Field-Programmable Gate Array » en anglais), ou un ASIC (« Application-Specific Integrated Circuit » en anglais).

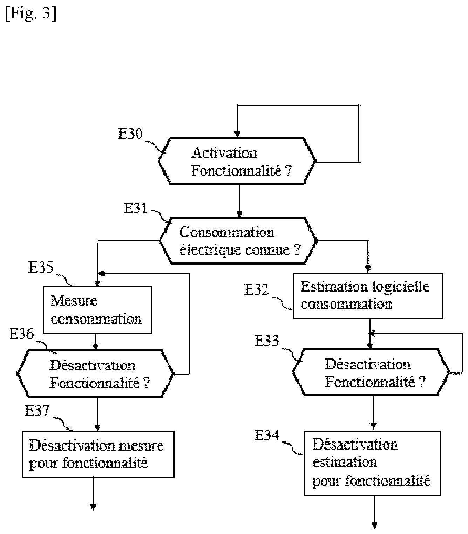

La Fig. 3 représente un exemple d'algorithme d'évaluation de la quantité d'énergie électrique consommée par un compteur communicant selon la présente invention.

Le présent algorithme est exécuté par l'unité de contrôle 100.

Selon l'invention, une table est mémorisée dans la mémoire ROM 203 qui associe à au moins une fonctionnalité de l'objet communicant une consommation en énergie électrique.

La consommation en énergie électrique est par exemple déterminée à partir de mesures de consommation en énergie électrique effectuées en laboratoire pour des objets communicants de même type et/ou à partir de données fournies par le fabriquant des composants électroniques utilisés dans l'exécution de la fonctionnalité. Par exemple, à la fonctionnalité affichage sur un écran est associée une consommation en énergie électrique, à la fonctionnalité mesure de débit du fluide est associée une consommation en énergie électrique, à la fonctionnalité communication par un lien Bluetooth est associée une consommation en énergie électrique, à la fonctionnalité communication par un lien optique est associée une consommation en énergie électrique.

Dans un mode particulier, la table associe à au moins une fonctionnalité de l'objet communicant des valeurs de consommation en énergie électrique pour différentes températures.

Certaines fonctionnalités telles que par exemple une communication radio de type LTE Cat-M sont soumises à des variations importantes, par exemple liées aux dispersions de l'impédance de l'antenne, aux conditions de communication liées à l'environnement. Selon l'invention, aucune consommation en énergie électrique n'est associée à ces fonctionnalités.

A l'étape E30, l'unité de contrôle 100 vérifie si une nouvelle fonctionnalité est activée.

Si une nouvelle fonctionnalité est activée, l'unité de contrôle 100 passe à l'étape E31.

A l'étape E31, l'unité de contrôle vérifie si à la fonctionnalité activée, une consommation en énergie électrique est associée en interrogeant la table.

Dans l'affirmative, l'unité de contrôle 100 passe à l'étape E32. Dans la négative, l'unité de contrôle 100 passe à l'étape E35.

A l'étape E32, l'unité de contrôle 100 commande une estimation de la quantité d'énergie électrique consommée par la fonctionnalité activée.

Plus précisément, l'unité de contrôle 100 active un compteur temporel associé à la fonctionnalité activée.

A l'étape suivante E33, l'unité de contrôle 100 vérifie si la fonctionnalité est désactivée. Dans l'affirmative, l'unité de contrôle 100 passe à l'étape E34.

A l'étape E34, l'unité de contrôle désactive l'estimation logicielle de la consommation en énergie électrique de la fonctionnalité, mémorise la valeur du compteur temporel associé à la fonctionnalité activée et interrompt le compteur temporel associé à la fonctionnalité activée.

A l'étape E35, l'unité de contrôle 100 commande une mesure de la quantité d'énergie électrique consommée par la fonctionnalité activée et active un compteur temporel associé à la fonctionnalité activée.

La mesure de la quantité d'énergie électrique consommée par la fonctionnalité activée est par exemple effectuée en mesurant le courant traversant une résistance de faible valeur placée entre la pile et les composants auxquels l'énergie électrique est fournie.

Les mesures du courant sont mémorisées.

Il est à remarquer ici que la mesure du courant est faite pour l'ensemble des composants de l'objet communicant ou seulement pour les composants de la fonctionnalité activée.

A l'étape suivante E36, l'unité de contrôle 100 vérifie si la fonctionnalité est désactivée.

Dans l'affirmative, l'unité de contrôle 100 passe à l'étape E37. Dans la négative, l'unité de contrôle 100 retourne à l'étape E35.

A l'étape E37, l'unité de contrôle désactive la mesure de la consommation en énergie électrique de la fonctionnalité, mémorise la valeur du compteur temporel associé à la fonctionnalité activée et interrompt le compteur temporel associé à la fonctionnalité activée.

Il est à remarquer que dans un mode particulier, la mesure de la consommation en énergie électrique de la fonctionnalité activée et l'estimation de la consommation en énergie électrique de la fonctionnalité activée peuvent être effectuées simultanément d'une manière temporaire pour vérifier si l'estimation de la consommation en énergie électrique de la fonctionnalité activée correspond à la consommation réelle en énergie électrique de la fonctionnalité activée et dans la négative modifie la valeur de la consommation en énergie électrique associée à la fonctionnalité.

Dans un mode particulier, lorsque la mesure du courant consommé par une fonctionnalité activée est stable dans le temps, par exemple fluctue dans une plage de valeurs de +/- 5%, la valeur mesurée est associée à la fonctionnalité activée et est mémorisée dans la table. La capacité en énergie électrique restante dans la pile est déterminée par exemple à partir de la formule suivante :
*Cr = C*₀ - Σ*ᵢ Dᵢ* ∗ *Iᵢ* où Cr est la capacité en énergie électrique restante dans la pile, C₀ est la capacité en énergie électrique initiale de pile, Dᵢ est la valeur du compteur temporel associé à la fonctionnalité i et Iᵢ est la valeur de consommation en énergie électrique associée à la fonctionnalité i ou la valeur du courant mesuré pour la fonctionnalité i.

## Revendications

1. Procédé d'évaluation de la quantité d'énergie électrique consommée par un objet communicant alimenté par pile, l'objet communicant étant apte à exécuter une pluralité de fonctionnalités, caractérisé en que le procédé comporte les étapes de :
- détection (E30) d'une activation d'une fonctionnalité de l'objet communicant,
- vérification (E31) dans une table si une consommation en énergie électrique est associée à la fonctionnalité activée,
- commande (E32) d'une estimation de la quantité d'énergie électrique consommée par la fonctionnalité activée si une consommation en énergie électrique est associée à la fonctionnalité activée,
- commande (E35) d'une mesure de la quantité d'énergie électrique consommée par la fonctionnalité activée si une consommation en énergie électrique n'est pas associée à la fonctionnalité activée.

2. Procédé selon la revendication 1, **caractérisé en ce que** l'objet communicant est un compteur de fluide communicant.

3. Procédé selon la revendication 2, **caractérisé en ce que** la pluralité de fonctionnalités comporte au moins une fonctionnalité affichage sur un écran, une fonctionnalité mesure de débit de fluide et une fonctionnalité communication par un canal radio.

4. Procédé selon la revendication 1 ou 2, **caractérisé en ce que**, si dans la table une consommation en énergie électrique est associée à la fonctionnalité activée, le procédé comporte en outre les étapes de :
- commande d'une mesure de la quantité d'énergie électrique consommée par la fonctionnalité activée,
- vérification si l'estimation de la consommation en énergie électrique de la fonctionnalité activée correspond à la mesure de la consommation en énergie électrique de la fonctionnalité activée,
- modification dans la table de la valeur de la consommation en énergie électrique associée à la fonctionnalité si l'estimation de la consommation en énergie électrique de la fonctionnalité activée ne correspond pas à la mesure de la consommation en énergie électrique de la fonctionnalité activée.

5. Procédé selon les revendications 2 à 4, **caractérisé en ce que** lorsque la mesure de la quantité d'énergie électrique consommée par une fonctionnalité activée est stable dans le temps, la valeur mesurée est associée à la fonctionnalité activée et est mémorisée dans la table.

6. Dispositif d'évaluation de la quantité d'énergie électrique consommée par un objet communicant alimenté par pile, l'objet communicant étant apte à exécuter une pluralité de fonctionnalités, caractérisé en que le dispositif comporte :
- des moyens de détection d'une activation d'une fonctionnalité de l'objet communicant,
- des moyens de vérification dans une table, si une consommation en énergie électrique est associée à la fonctionnalité activée,
- des moyens de commande d'une estimation de la quantité d'énergie électrique consommée par la fonctionnalité activée si une consommation en énergie électrique est associée à la fonctionnalité activée,
- des moyens de commande d'une mesure de la quantité d'énergie électrique consommée par la fonctionnalité activée si une consommation en énergie électrique n'est pas associée à la fonctionnalité activée.

7. Produit programme d'ordinateur comprenant des instructions de code de programme pour exécuter le procédé selon l'une quelconque des revendications 1 à 5, lorsque lesdites instructions sont exécutées par un processeur.

8. Support de stockage non transitoire sur lequel est stocké un programme d'ordinateur comprenant des instructions de code de programme pour exécuter le procédé selon l'une quelconque des revendications 1 à 5, lorsque lesdites instructions sont lues depuis ledit support de stockage non transitoire et exécutées par un processeur.
